# FASCICULE DE BREVET EUROPEEN

(11) **EP 2 896 278 B1**
(45) Date de publication et mention de la délivrance du brevet: **12.06.2019**
(21) Numéro de dépôt: 13774719.2
(22) Date de dépôt: 04.09.2013
(51) Int. Cl.: H05H 1/46, H01J 37/32

(54) **DISPOSITIF POUR GÉNÉRER UN PLASMA PRÉSENTANT UNE ÉTENDUE IMPORTANTE LE LONG D'UN AXE PAR RÉSONNANCE CYCLOTRONIQUE ÉLECTRONIQUE RCE À PARTIR D'UN MILIEU GAZEUX.**
VORRICHTUNG ZUR PLASMAERZEUGUNG MIT HOHEM BEREICH ENTLANG EINER ACHSE DURCH ELEKTRONZYKLOTRONRESONANZ (ECR) AUS EINEM GASFÖRMIGEN MEDIUM
DEVICE FOR GENERATING PLASMA HAVING A HIGH RANGE ALONG AN AXIS BY ELECTRON CYCLOTRON RESONANCE (ECR) FROM A GASEOUS MEDIUM

(30) Priorité: 11.09.2012 FR 1258495
(43) Date de publication de la demande: 22.07.2015
(73) Titulaire: H.E.F., 42160 Andrezieux-Boutheon (FR)
(72) Inventeur: SCHMIDT, Beat, F-42210 Montrond Les Bains (FR); HEAU, Christophe, F-42100 Saint Etienne (FR); MAURIN-PERRIER, Philippe, F-42680 Saint Marcellin en Forez (FR)
(74) Mandataire: Cabinet Laurent & Charras
(86) Numéro de dépôt international: PCT/FR2013/052035
(87) Numéro de publication internationale: WO 2014/041280

(56) Documents cités:
- EP-A1- 1 976 346
- WO-A1-2008/009558
- US-A- 4 745 337
- US-A- 5 961 773

## Description

L'invention se rattache au secteur technique de la production de plasma par résonance cyclotronique électronique (RCE) à partir d'un milieu gazeux et concerne plus particulièrement le domaine des traitements de surface sous vide.

D'une manière parfaitement connue pour un homme du métier, la résonance cyclotronique électronique a lieu quand on applique en même temps une onde électromagnétique et un champ magnétique statique suffisamment fort pour que la fréquence du mouvement cyclotronique des électrons autour des lignes de champ magnétique soit égale à la fréquence de l'onde. Ainsi les électrons peuvent absorber l'énergie de l'onde pour la transmettre ensuite au gaz pour former un plasma. Le plasma généré par résonance cyclotronique électronique peut intervenir dans le traitement de surface de pièces métalliques ou non, tel que le nettoyage des pièces par décapage ionique, l'assistance ionique à un procédé de dépôt PVD, l'activation d'espèces gazeuses pour faire des revêtements PACVD... Ces méthodes de traitement de surface par plasma peuvent être utilisées, entre autres, dans le domaine de la mécanique, de l'optique, de la protection corrosion ou le traitement de surface pour la production d'énergie.

Selon l'état de la technique, de nombreux traitements par voie plasma nécessitent une source dont le plasma présente une étendue importante le long d'un axe. Une façon de créer un plasma étendu est de juxtaposer plusieurs sources de petites dimensions. Ceci est décrit par exemple dans le brevet EP 1075168 où le plasma est créé par la juxtaposition de plusieurs sources RCE dipolaires, créant ainsi une structure multi-dipolaire. La configuration décrite dans ce brevet est illustrée dans la figure 1. La résonance cyclotronique électronique (RCE) aux fréquences micro-ondes est une technologie qui se prête bien pour de telles sources multiples car la distribution de la puissance se fait assez facilement. Il est cependant difficile avec cette simple juxtaposition de sources d'obtenir une très bonne uniformité de dépôt. De plus, la structure dipolaire de ces sources ne permet pas d'orienter le plasma vers les substrats à traiter, engendrant ainsi des pertes importantes de plasma vers les parois. Ces pertes correspondent à des pertes d'énergie qui sont limitant pour la vitesse de dépôt.

D'autres sources RCE ont des configurations magnétiques qui réduisent ces pertes en orientant le plasma davantage vers les substrats à traiter. Ceci est par exemple le cas de la source décrite dans le brevet WO 2008/017304 (Fig. 2). Comme spécifié dans ce brevet, plusieurs de ces sources mises côte à côte autorisent le traitement sur une largeur dépassant la taille d'une seule source. Cependant, une telle configuration ne donnera pas une bonne uniformité de traitement, il y aura forcément une chute en densité de plasma là où les sources se touchent à cause de l'interaction magnétique entre les sources.

D'autres sources de plasma RCE qui présentent une étendue intrinsèque importante dans une direction existent. De telles sources sont décrites dans les brevets DE 4136297, DE 19812558 et WO 2005/027595. Le point commun de ces sources est que le plasma lui-même forme une partie du conducteur extérieur d'une structure coaxiale ou d'un guide d'onde creux. La figure 3, qui correspond à l'art antérieur du brevet DE 19812558, montre de façon représentative la structure d'une telle source. La source du brevet DE 4136297 possède un cylindre creux réalisé dans une matière diélectrique qui sépare l'intérieur du guide d'onde du plasma. L'inconvénient de cet élément est que tout dépôt conducteur sur sa surface empêchera la formation du plasma. Une telle source ne pourra pas par exemple être utilisée pour le décapage de pièces métalliques car la vapeur métallique émanant du décapage polluerait le diélectrique. Les sources des brevets DE 19812558 et WO 2005/027595 sont potentiellement moins sensibles à une telle contamination, mais elles n'optimisent pas non plus le flux de plasma vers les pièces à traiter.

US 4,745,337 divulgue un autre exemple de production et confinement de plasma dans une enceinte fermée.

L'invention s'est fixée pour but de remédier à ces inconvénients de manière simple, sûre, efficace et rationnelle.

Le problème que se propose de résoudre la présente invention est donc de fournir une source de plasma linéaire de bonne uniformité, qui oriente le plasma vers les substrats à traiter, diminuant ainsi les pertes vers les parois, et qui peut être rendue insensible à tout dépôt conducteur qui se fait à sa surface.

Pour résoudre un tel problème, il a été conçu et mis au point un dispositif pour générer un plasma par résonnance cyclotronique électronique RCE à partir d'un milieu gazeux et comportant au moins deux guides d'onde coaxiaux constitués d'un conducteur central et d'un conducteur extérieur pour amener des micro-ondes dans une chambre de traitement, caractérisé en ce qu'au moins les deux guides d'injection d'ondes électromagnétique sont combinés avec un circuit magnétique allongé dans une direction, ledit circuit magnétique entourant les guides d'onde en créant un champ magnétique apte à réaliser une condition de RCE à proximité desdits guides d'onde. Par proximité on entend que la zone RCE doit être au plus proche de l'antenne, sans que les lignes de champ magnétique traversant la zone RCE ne soient majoritairement interceptées par l'antenne d'une injection.

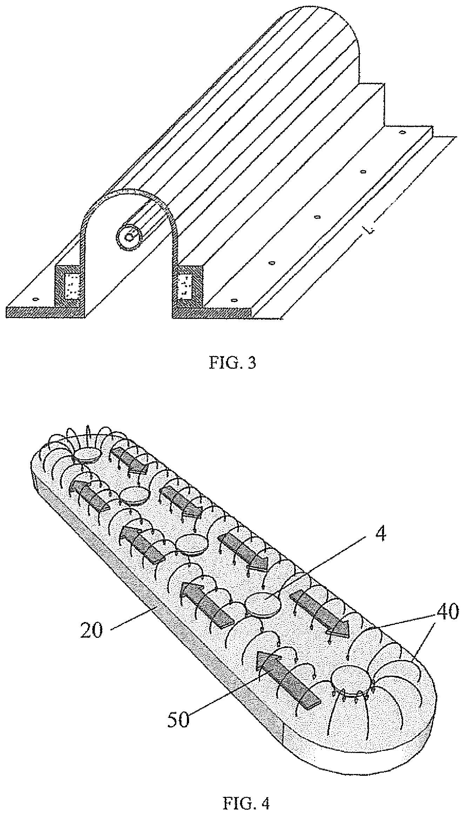

Il ressort de ces caractéristiques que le caractère ponctuel de l'injection des ondes électromagnétiques est lissé par la dérive des électrons (symbolisé par une flèche (50) dans la figure 4) dans le champ du système magnétique (20) qui entoure ces injections (4) en rappelant qu'une injection (4) est constituée d'un guide d'onde coaxial (1)-(2) et d'une antenne (5-6 ou 7). Par dérive, on entend le mouvement lent des électrons perpendiculaire aux lignes de champ (40). Ce mouvement est dû au gradient et à la courbure de ces lignes. En effet, l'espace entre deux injections reçoit par dérive les électrons chauds issus des zones de résonance des deux injections. En dérivant, les électrons perdent leur énergie en créant des ions. Le taux d'ionisation diminue en s'éloignant de l'injection, mais les deux dérives opposées s'additionnent ce qui fait que l'intensité de la source varie peu en fonction de la position le long de sa grande longueur.

Pour résoudre le problème posé de former un piège magnétique pour les électrons afin d'en limiter les pertes, le circuit magnétique présente à proximité des guides d'onde, deux pôles de polarité opposés. Le premier pôle forme une première ligne entourant le ou les guides d'onde, tandis que le deuxième pôle forme une deuxième ligne, entourant ladite première ligne.

On rappelle selon l'invention que les injections d'ondes sont formées par des guides coaxiaux dont le conducteur central se termine par une antenne. Or, il n'est pas évident pour un homme du métier qu'un tel système fonctionne car un circuit magnétique allongé dans une direction, tel que revendiqué, ne permet pas à la zone de RCE d'entourer le point d'injection comme cela est le cas par exemple de la source du brevet précité WO 2008/017304. En effet, le transfert d'énergie vers le plasma devient plus difficile parce que premièrement le volume de RCE à proximité des injections est plus petit et, deuxièmement, l'environnement de l'antenne n'est pas homogène : l'onde passe d'un guide à symétrie de révolution dans un milieu (plasma) qui n'a pas cette symétrie et l'onde est de ce fait partiellement réfléchie. Ce deuxième point pose surtout problème parce que le système subit une transition quand le plasma s'allume : avant l'allumage du plasma le milieu (vide) est homogène, mais après il ne l'est plus. Cette transition constitue un changement d'impédance qui est difficile à gérer. Les injections sont en général équipées d'un dispositif d'adaptation d'impédance, mais ces dispositifs sont habituellement manuels et pas prévus pour une modification pendant le procédé

Pour ces différentes raisons, il a été nécessaire de développer différentes formes d'antennes spécifiquement adaptées au fonctionnement du dispositif avec un système magnétique allongé.

Dans ce but, dans une première forme de réalisation, le conducteur central présente un disque concentrique de diamètre plus grand que l'ouverture du guide d'onde afin de protéger l'intérieur dudit guide, qui est positionné au plus proche de la zone RCE et est surmonté par une tige disposée en alignement coaxial avec le conducteur central.

Dans une deuxième forme de réalisation, le conducteur central est terminé par une plaque allongée selon l'axe le plus long du circuit magnétique, l'une des extrémités au moins de ladite plaque présentant des agencements pour être mise en contact avec la surface de la source, pour créer un court-circuit, la largeur de la plaque étant supérieure à l'ouverture du guide d'onde.

La largeur de la plaque est constante sur la totalité de sa longueur, ou bien la largeur de la plaque diminue en s'éloignant du conducteur central, et par rapport à au moins un côté dudit conducteur.

A partir des caractéristiques à la base de l'invention, le dispositif est applicable dans le cas d'une chambre de traitement comprenant un corps avec un circuit de refroidissement, ledit corps présentant un logement pour le montage du circuit magnétique allongé composé de la première ligne d'aimants selon la première polarisation et la seconde ligne d'aimants selon une polarisation opposée et entourant la première ligne laquelle entoure les guides d'ondes montés dans des trous formés dans l'épaisseur du corps, les première et seconde ligne d'aimants sont reliées du côté opposé au plasma, par une plaque ferromagnétique, le corps et le système magnétique étant séparés du plasma par une tôle de protection amagnétique.

En considérant les différentes formes possibles des antennes, afin de les adapter au fonctionnement du système magnétique allongé :
- soit le conducteur central de chaque guide est une tige cylindrique centrée par rapport au conducteur extérieur inséré dans le corps en formant un bon contact électrique, une fenêtre diélectrique étant placée à l'intérieur du guide en dessous de l'ouverture qui est couverte par le disque surmonté de la tige pour faire office d'antenne.
- soit le conducteur central de chaque guide est une tige cylindrique centrée par rapport aux conducteurs extérieurs insérés dans le corps en formant un bon contact électrique, une fenêtre diélectrique étant placée à l'intérieur du guide en dessous de l'ouverture, qui est couverte par la plaque allongée le long de l'axe des injections, ledit allongement étant asymétrique par rapport au conducteur central pour un guide d'onde situé à une extrémité arrondie du circuit magnétique, l'allongement se faisant uniquement dans la direction de l'extrémité opposée et symétrique par rapport au conducteur central pour un guide d'onde situé dans la partie linéaire du circuit magnétique, chaque partie allongée présentant l'agencement faisant office de court-circuit.

L'invention est exposée ci-après plus en détail à l'aide des dessins annexés dans lesquels :

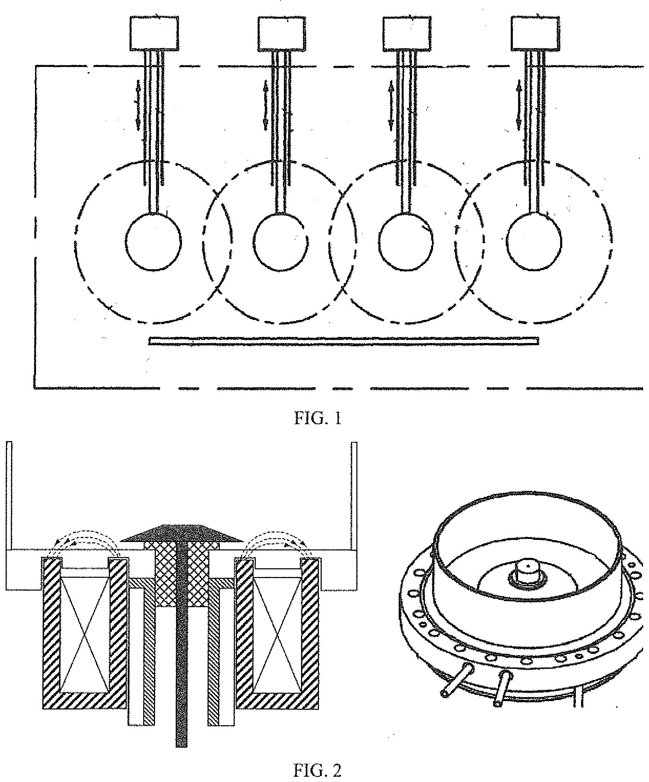

- La fig. 1 est une vue schématique de l'art antérieur décrit dans le brevet EP 1075168.
- La fig. 2 est une vue schématique de l'art antérieur décrit dans le brevet WO 2008/017304.
- La fig. 3 est une vue schématique de l'art antérieur décrit dans le brevet DE 19812558.
- La fig. 4 est une vue schématique du principe de la présente invention.
- Les fig. 5A et 5B présentent des possibles formes de réalisation de la structure magnétique, conformes à l'invention.
- La fig. 6 montre une première forme d'antenne conforme à l'invention.
- Les fig. 7A, 7B et 7C montrent d'autres formes d'antennes conformes à l'invention.
- La fig. 8 est une vue en perspective d'une première réalisation de la présente invention présentant une coupe au niveau d'une arrivée de micro-ondes.
- La fig. 9 est une vue en perspective d'une deuxième réalisation de la présente invention présentant une coupe dans le plan des injections micro-onde et une deuxième coupe entre deux injections perpendiculairement à ce plan.

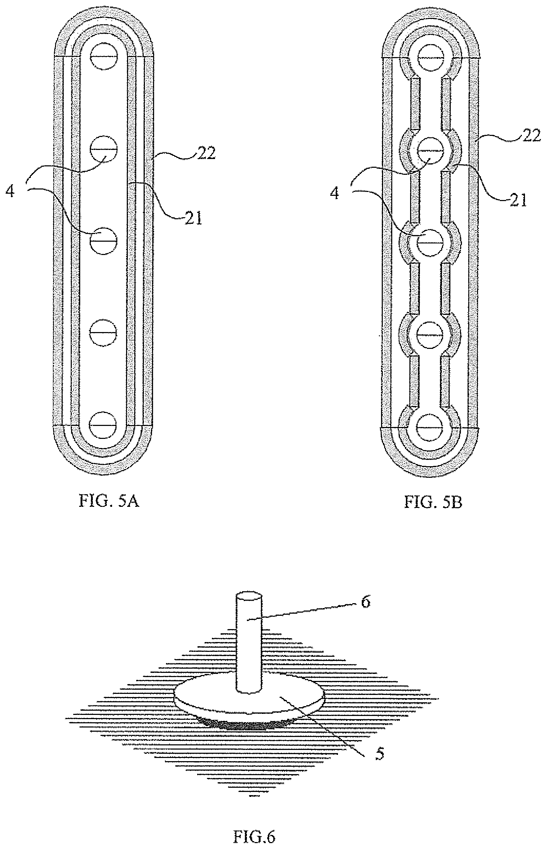

Le principe de base de l'invention c'est-à-dire le circuit magnétique allongé entourant plusieurs injections de micro-ondes est illustré de manière schématique dans les figures 4 et 5.

Le circuit magnétique présente au voisinage de la surface de la source deux pôles de polarité opposée afin de former un piège magnétique pour les électrons. Le premier pôle forme une première ligne (21) entourant les guides d'injection (4) des ondes électromagnétiques et le deuxième pôle forme une deuxième ligne (22) entourant cette première ligne.

La figure 5 montre deux formes possibles pour ce circuit magnétique. La première (Fig. 5A) a l'avantage d'être plus simple à réaliser, mais la zone RCE est tangentielle aux injections dans la partie linéaire. La deuxième forme (Fig. 5B) tente d'optimiser le volume RCE à proximité des injections.

En réglant la force relative des 2 pôles de la structure magnétique il est possible d'influencer le flux de plasma vers les substrats à traiter. Par exemple, en renforçant le pôle extérieur du circuit (22) on va faire converger les 2 bandes de plasma de la partie linéaire dans l'espace devant la source ce qui permet d'augmenter à cet endroit la vitesse de traitement des pièces. Cela est utile pour réduire les pertes latérales si les parois de l'enceinte à vide sont proches. Si on renforce au contraire le pôle intérieur du circuit (21), les 2 bandes de plasma s'écartent latéralement. Dans certains cas cela peut présenter un avantage comme, par exemple, pour une surface de traitement cylindrique pour laquelle on peut ainsi créer 2 zones de traitement tangentes à la surface du cylindre.

Les injections d'onde sont formées par des guides coaxiaux dont le conducteur central se termine par une antenne.

L'invention propose deux façons d'optimiser la forme des antennes.

Les exemples numériques suivants sont donnés pour une source de plasma comprenant des guides d'ondes coaxiaux dont les conducteurs extérieurs ont des diamètres intérieurs de 17 mm et dont les conducteurs intérieurs ont des diamètres extérieurs de 8 mm.

Dans une première forme de réalisation, illustrée dans la figure 6, le conducteur central (1) s'élargit d'abord en forme de disque (5). Ce disque a un diamètre plus grand que l'ouverture du guide d'onde (1) - (2) ce qui permet de protéger l'intérieur du guide d'un éventuel dépôt et d'amener l'onde au plus proche de la zone RCE. Son bord se situe en effet à quelques millimètres de la zone RCE. Ce disque a une épaisseur de quelques millimètres, typiquement entre 1 et 5 mm, et forme avec la surface de la source une fente de quelques millimètres, avantageusement entre 2 et 5 mm. Ce disque est surmonté par une tige (6) qui se trouve dans la prolongation du conducteur central (1). La longueur de cette tige se situe entre λ/8 et λ/2, λ étant la longueur d'onde des micro-ondes. La longueur exacte dépend du diamètre du disque et de la forme de la zone RCE. C'est en ajustant la longueur de cette tige que l'on optimise l'antenne. Par exemple, dans une réalisation avec un disque de diamètre 25 mm, la longueur optimale pour la tige se situe entre 30 et 35 mm pour une longueur d'onde de 122,4 mm (2,45 GHz). Ainsi, malgré sa symétrie de révolution cette antenne produit un bon couplage du champ micro-ondes au plasma. La fonction de la tige est d'accorder l'impédance du vide à celle du plasma.

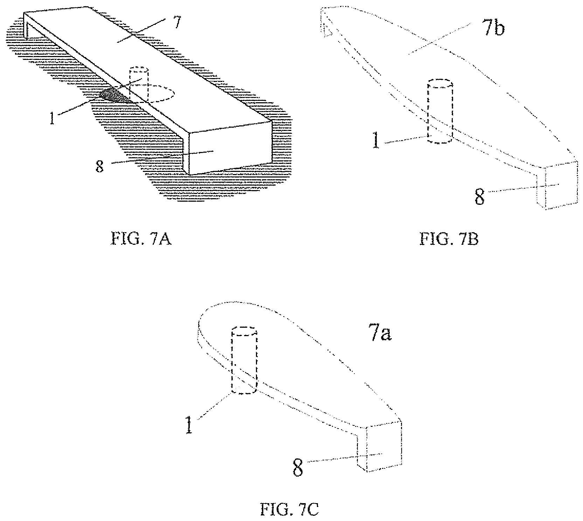

Dans une deuxième forme de réalisation, le conducteur central se termine par une plaque (7) de quelques millimètres d'épaisseur, qui, cette fois-ci, n'a pas la symétrie de révolution, mais est allongée le long de l'axe le plus long du système magnétique (Fig. 7A-7B). En largeur cette plaque dépasse l'ouverture du guide d'onde et se termine à quelques millimètres de la zone RCE. Sa longueur totale est comprise entre λ/4 et λ. En ajustant cette longueur il est possible d'optimiser le couplage vers le plasma. Aux extrémités cette plaque est mise en contact (8) avec la surface de la source pour créer un court-circuit, évitant ainsi qu'elle rayonne des micro-ondes vers les plaques voisines. Ce court-circuit force l'onde à produire à cette endroit un noeud dans le champ électrique. L'onde se réfléchit et retourne vers le point d'injection. La distance entre le point d'injection et le retour à la masse fixe la phase de l'onde réfléchit quand elle atteint le point d'injection. En modifiant cette distance il est possible d'ajuster cette phase à celle de l'onde réfléchie par le plasma. Une solution « naturelle » semble celle où la longueur totale de la plaque fait λ/2, c'est-à-dire 61 mm pour une fréquence de 2,45 GHz, longueur pour laquelle une onde stationnaire se forme entre les 2 extrémités. Dans un cas réel nous avons cependant trouvé que cette longueur théorique n'était pas optimale pour le rendement plasma et qu'il fallait augmenter la longueur d'environ 10% pour obtenir des résultats satisfaisants.

La largeur de la plaque peut rester la même sur toute la longueur de la plaque (Fig. 7A) ou diminuer en s'éloignant du point d'injection (Fig. 7B). Dans une réalisation préférentielle la largeur de la plaque diminue en approchant son extrémité. Par exemple, pour une plaque qui fait 25 mm de large au milieu, la largeur ne fera plus que 10 mm aux extrémités.

Pour une injection qui se situe à l'intérieur d'un virage du circuit magnétique, cette deuxième forme d'antenne est modifiée de telle façon que la plaque n'est allongée que dans la direction qui s'éloigne du virage (Fig. 7C). La longueur de cette partie, mesurée à partir du centre du guide centrale, est alors comprise entre λ/8 et λ/2. Du côté du virage la plaque présente la forme d'un demi-disque. Dans un exemple de réalisation avec un demi-disque d'un rayon de 12,5 mm, la partie allongée mesure 34 mm, toujours pour un λ de 122,4 mm (2,45 GHz).

Il est possible de combiner sur une même source plusieurs types d'antennes pour optimiser la performance générale. Il est également possible de combiner les deux solutions que propose l'invention comme par exemple la plaque allongée surmontée d'une tige.

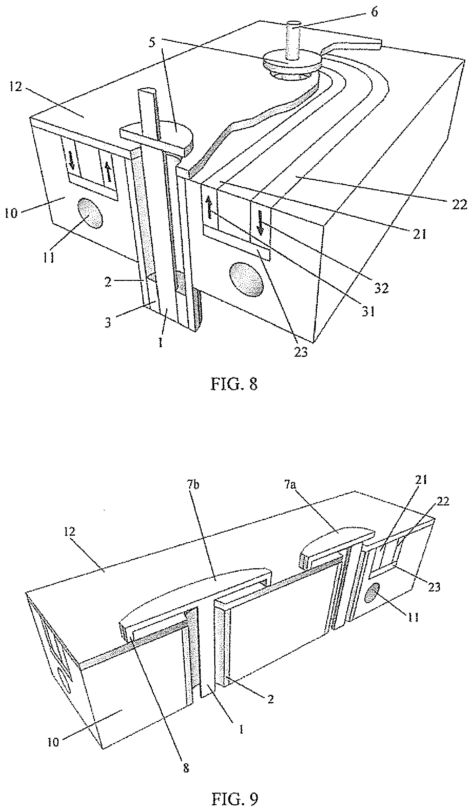

On renvoie aux figures 8 et 9 qui montrent en coupe deux formes de réalisation de source de plasma intégrant le dispositif selon l'invention.

A la figure 8, la chambre de traitement comprend un corps métallique amagnétique (10) refroidi par de l'eau circulant dans un circuit de refroidissement (11). Un logement prévu dans ce corps reçoit le système magnétique. Dans cette réalisation le système magnétique est composé de la première ligne d'aimants (21) d'une première polarisation (31) et de la deuxième ligne (22) entourant cette première ligne et de polarisation opposée (32). A l'intérieur du corps (10) les deux lignes d'aimants (21) et (22) sont reliées par une plaque ferromagnétique (23). Le corps (10) et le système magnétique, sont séparés du plasma par une tôle de protection (12). Des trous cylindriques sont prévus dans le corps (10) et la tôle (12) pour l'injection des micro-ondes, au moyen de plusieurs guides coaxiaux dont les conducteurs extérieurs (2) s'insèrent dans le corps de la source en formant un bon contact électrique avec celle-ci. Le conducteur central de chaque guide se présente sous forme d'une tige cylindrique (1), centrée par rapport au conducteur extérieur, et qui dépasse la tôle de protection. Une fenêtre diélectrique (3) est placée à l'intérieur du guide à plusieurs centimètres de l'ouverture. Cet emplacement déporté garantit un faible encrassement du diélectrique par un quelconque dépôt et notamment par un dépôt conducteur qui pourrait empêcher le passage des micro-ondes. Le diélectrique permet de faire l'étanchéité entre l'intérieur et l'extérieur de l'enceinte de traitement sous vide. Dans cette première réalisation, l'ouverture du guide d'onde est couverte par un disque (5) qui empêche le dépôt de rentrer dans le guide d'onde et permet d'amener les micro-ondes vers la zone de RCE. Le disque (5) est surmonté d'une tige (6) qui permet d'optimiser le couplage avec le plasma.

Ainsi, dans une réalisation où le disque circulaire a un diamètre de 25 mm et une épaisseur de 3 mm, la longueur de la tige a été ajustée entre 16 et 35 mm pour une fréquence micro-onde de 2,45 GHz et une puissance par antenne de 90 W. Dans chaque configuration, on observe la facilité d'allumage. L'allumage est considéré facile s'il ne nécessite pas de modification au niveau des dispositifs d'adaptation d'impédance qui se trouvent sur chaque ligne d'injection.

Des mesures du courant électrique extrait du plasma et récolté par des substrats placés à 8 cm de la source et portés à une tension de 20V, ont été effectuées comme il ressort du tableau ci-après :

| Longueur tige | 16 mm | 20 mm | 30 mm | 35 mm |
|---|---|---|---|---|
| Courant mesuré | 1,37 A | 1,38 A | 1,41 A | 1,41 A |
| Allumage facile | non | Oui | Oui | oui |

La variation du courant, bien que faible du fait que l'accord d'impédance a été optimisé dans chaque configuration pour garantir un transfert optimal de la puissance vers le plasma, est suffisamment significative pour permettre de déterminer une longueur optimale située entre 30 et 35 mm dans cette configuration.

Dans la forme de réalisation illustrée figure 9, la conception de base de la chambre de traitement est la même. La différence se situe au niveau des antennes. Dans cette forme de réalisation, les plaques (7a) et (7b) des antennes sont allongées le long de l'axe des injections. L'allongement (7a) est asymétrique par rapport au conducteur central (1) pour une antenne qui se situe à une extrémité de la source plasma, au centre d'un virage du circuit magnétique, l'allongement ne se faisant que dans la direction de l'extrémité opposée. L'allongement (7b) est symétrique par rapport au conducteur central pour une antenne qui se situe dans la partie linéaire du circuit magnétique. Au bout de chaque partie allongée se trouve un court-circuit (8) qui évite que l'antenne rayonne vers sa voisine. Dans la présente réalisation, la largeur de la plaque diminue à mesure qu'on s'éloigne du conducteur central (1) et qu'on s'approche du retour à la masse.

Cette configuration a d'abord été testée avec des antennes dont la distance entre retour à la masse et conducteur centrale du guide d'onde était de 31 à 32mm, donc proche de λ/4 (30,6 mm). Cela a donné une augmentation du courant d'environ 3% par rapport à la première réalisation. En portant cette distance à 34 mm le courant augmente de 3% supplémentaires, donc de 6% par rapport à la première réalisation. Dans les deux cas la plaque avait une épaisseur de 3 mm.

Les avantages ressortent bien de la description.

## Revendications

1. Dispositif pour générer un plasma présentant une étendue importante le long d'un axe par résonnance cyclotronique électronique RCE à partir d'un milieu gazeux et comportant au moins deux guides d'onde coaxiaux (4) constitués chacun d'un conducteur central (1) et d'un conducteur extérieur (2) pour amener des micro-ondes dans une chambre de traitement, **caractérisé en ce qu'**au moins les deux guides d'injection d'ondes électromagnétique (4) sont combinés avec un circuit magnétique (21-22) allongé dans une direction, ledit circuit magnétique entourant les guides d'onde (4) en créant un champ magnétique apte à réaliser une condition de RCE à proximité desdits guides d'onde.

2. Dispositif selon la revendication 1, **caractérisé en ce que** le circuit magnétique présente à proximité des guides d'onde, deux pôles (21-22) de polarité opposés (31-32) afin de former un piège magnétique pour les électrons.

3. Dispositif selon la revendication 2, **caractérisé en ce que** le premier pôle (21) forme une première ligne entourant les guides d'onde (4), tandis que le deuxième pôle (22) forme une deuxième ligne, entourant ladite première ligne.

4. Dispositif selon la revendication 1, **caractérisé en ce que** le conducteur central (1) de chaque guide d'onde présente des agencements (7,8) aptes à protéger l'ouverture dudit guide et à faire office d'antennes

5. Dispositif selon la revendication 4, **caractérisé en ce que** le conducteur central (1) présente un disque concentrique (5) de diamètre plus grand que l'ouverture du guide d'onde (4) afin de protéger l'intérieur dudit guide, ledit guide étant positionné au plus proche de la zone RCE et est surmonté par une tige (6) disposée en alignement coaxial avec le conducteur central (1).

6. Dispositif selon la revendication 4, **caractérisé en ce que** le conducteur central est terminé par une plaque allongée (7) selon l'axe le plus long du circuit magnétique, l'une des extrémités au moins de ladite plaque présentant des agencements (8) pour être mise en contact avec la surface de la source, pour créer un court-circuit, la largeur de la plaque (7) étant supérieure à l'ouverture du guide d'onde (4)

7. Dispositif selon la revendication 6, **caractérisé en ce que** la largeur de la plaque (7) est constante sur la totalité de sa largeur.

8. Dispositif selon la revendication 6, **caractérisé en ce que** la largeur de la plaque (7) diminue en s'éloignant du conducteur central (1), et par rapport à au moins un côté dudit conducteur (1).

9. Dispositif selon l'une quelconque des revendications 1-8, **caractérisé en ce que** la chambre de traitement comprend un corps (10) avec un circuit de refroidissement (11), ledit corps (10) présentant un logement pour le montage du circuit magnétique allongé composé de la première ligne d'aimants (21) selon la première polarisation et la seconde ligne d'aimants (22) selon une polarisation opposée et entourant la première ligne (21) laquelle entoure les guides d'ondes (4) montés dans des trous formés dans l'épaisseur du corps (10), la première et seconde ligne d'aimants sont reliées par une plaque ferromagnétique (23), le corps et le système magnétique étant séparés du plasma par une tôle de protection (12).

10. Dispositif selon l'une quelconque des revendications 1-9, **caractérisé en ce que** le conducteur central (1) est une tige cylindrique centrée par rapport au conducteur extérieur inséré dans le corps (10) en formant un bon contact électrique, une fenêtre diélectrique (3) étant placée à l'intérieur du guide (4) en dessous de l'ouverture qui est couverte par le disque surmonté de la tige pour faire office d'antenne.

11. Dispositif selon l'une quelconque des revendications 1-9, **caractérisé en ce que** le conducteur central est une tige cylindrique centrée par rapport au conducteur extérieur inséré dans le corps (10) en formant un bon contact électrique, une fenêtre diélectrique (3) étant placée à l'intérieur du guide (4) en dessous de l'ouverture, qui est couverte par la plaque allongée (7) le long de l'axe des injections, ledit allongement étant asymétrique par rapport au conducteur central pour un guide d'onde situé à une extrémité arrondie du circuit magnétique, l'allongement se faisant uniquement dans la direction de l'extrémité opposée et symétrique par rapport au conducteur central par un guide d'onde situé dans la partie linéaire du circuit magnétique, chaque partie allongée présentant l'agencement (8) faisant office de court-circuit.

## Patentansprüche

1. Vorrichtung zur Erzeugung eines Plasmas mit erheblicher Ausdehnung entlang einer Achse durch Elektron-Zyklotron-Resonanz EZR, ausgehend von einem gasförmigen Milieu und umfassend mindestens zwei koaxiale Wellenleiter (4), jeweils bestehend aus einem zentralen Leiter (1) und einem äußeren Leiter (2) um die Mikrowellen in eine Behandlungskammer zu leiten, **dadurch gekennzeichnet, dass** mindestens zwei Leiter zur Einspeisung elektromagnetischer Wellen (4) kombiniert sind mit einem in eine Richtung längs gestreckten Magnetkreis (21-22), dieser Magnetkreis umgibt die Wellenleiter (4) durch Erzeugung eines Magnetfeldes, das eine EZR - Bedingung in Nähe dieser Wellenleiter erfüllen kann.

2. Vorrichtung gemäß Anspruch 1, **dadurch gekennzeichnet, dass** der Magnetkreis in der Nähe der Wellenleiter zwei Pole (21-22) mit entgegengesetzter Polarität (31-32) aufweist, um eine Magnetfalle für die Elektronen zu bilden.

3. Vorrichtung gemäß Anspruch 2, **dadurch gekennzeichnet, dass** der erste Pol (21) eine erste Linie bildet, die die Wellenleiter (4) umgibt, während der zweite Pol (22) eine zweite Linie bildet, die diese erste Linie umgibt.

4. Vorrichtung gemäß Anspruch 1, **dadurch gekennzeichnet, dass** der zentrale Leiter (1) jedes Wellenleiters Einrichtungen (7, 8) aufweist, die geeignet sind, die Öffnung dieses Leiters zu schützen und als Antenne zu dienen.

5. Vorrichtung gemäß Anspruch 4, **dadurch gekennzeichnet, dass** der zentrale Leiter (1) eine konzentrische Scheibe (5) aufweist, deren Durchmesser größer ist als die Öffnung des Wellenleiters (4), um das Innere dieses Leiters zu schützen, dieser Leiter ist möglichst nahe an der EZR- Zone angeordnet und wird von einem Stift (6) überragt, der koaxial am zentralen Leiter (1) ausgerichtet ist.

6. Vorrichtung gemäß Anspruch 4, **dadurch gekennzeichnet, dass** der zentrale Leiter in einer Platte (7) endet, die sich entlang der längsten Achse des Magnetkreises verlängert, mindestens ein Ende dieser Platte weist Einrichtungen (8) auf, um mit der Oberfläche der Quelle in Kontakt gebracht zu werden und einen Kurzschluss zu erzeugen, die Breite der Platte (7) ist dabei größer als die Öffnung des Wellenleiters (4).

7. Vorrichtung gemäß Anspruch 6, **dadurch gekennzeichnet, dass** die Breite der Platte (7) über ihre gesamte Breite konstant ist.

8. Vorrichtung gemäß Anspruch 6, **dadurch gekennzeichnet, dass** die Breite der Platte (7) mit zunehmender Entfernung vom zentralen Leiter (1) und bezogen auf mindestens eine Seite dieses Leiters (1) abnimmt.

9. Vorrichtung gemäß einem der Ansprüche 1-8, **dadurch gekennzeichnet, dass** die Behandlungskammer ein Gehäuse (10) mit einem Kühlkreislauf (11) umfasst, dieses Gehäuse (10) weist eine Unterbringung zur Montage des verlängerten Magnetkreises auf, der besteht aus der ersten Magnetlinie (21) entsprechend der ersten Polarisation und der zweiten Magnetlinie (22) entsprechend der entgegengesetzten Polarisation, die die erste Magnetlinie (21) umgibt, welche wiederum den Wellenleiter (4) umgibt, montiert in Löcher, die in der Dicke des Gehäuses (10) vorgesehen sind, die erste und zweite Magnetlinie sind über eine ferromagnetische Platte (23) verbunden, das Gehäuse und das Magnetsystem sind vom Plasma durch ein Schutzblech (12) getrennt.

10. Vorrichtung gemäß einem der Ansprüche 1-9, **dadurch gekennzeichnet, dass** der zentrale Leiter (1) ein zylindrischer Stift ist, zentriert bezogen auf den äußeren Leiter, der im Gehäuse (10) eingesetzt ist und der einen guten elektrischen Kontakt bildet, ein dielektrisches Fenster (3) ist dabei im Inneren des Leiters (4) eingesetzt, unter der Öffnung, die von der Scheibe abgedeckt wird, die vom Stift überragt wird um als Antenne zu dienen.

11. Vorrichtung gemäß einem der Ansprüche 1-9, **dadurch gekennzeichnet, dass** der zentrale Leiter ein zylindrischer Stift ist, zentriert bezogen auf den äußeren Leiter, der im Gehäuse (10) eingesetzt ist und der einen guten elektrischen Kontakt bildet, ein dielektrisches Fenster (3) ist dabei im Inneren des Leiters (4) eingesetzt, unter der Öffnung, die von der länglichen Platte (7) entlang der Einspeisungsachse abgedeckt wird, diese längliche Form ist asymmetrisch bezogen auf den zentralen Leiter für einen an einem abgerundeten Endstück des Magnetkreises befindlichen Wellenleiter, die längliche Form verläuft ausschließlich in Richtung des entgegengesetzten Endstücks und symmetrisch, bezogen auf den zentralen Leiter, durch einen Wellenleiter, der in dem linearen Abschnitt des Magnetkreises untergebracht ist, jeder längliche Teil weist Einrichtungen (8) auf, die als Kurzschluss dienen.

## Claims

1. A device for generating a plasma of significant extension along an axis by electron cyclotron resonance ECR from a gaseous medium and comprising at least two coaxial waveguides (4) each formed of a central conductor (1) and of an external conductor (2) to bring microwaves into a treatment chamber, **characterized in that** at least the two electromagnetic wave injection guides (4) are combined with a magnetic circuit (21-22) elongated in one direction, said magnetic circuit surrounding the waveguides (4) by creating a magnetic field capable of achieving an ECR condition close to said waveguides.

2. Device according to claim 1, **characterized in that** the magnetic circuit has, close to the waveguides, two poles (21-22) of opposite polarities (31-32) to form a magnetic trap for electrons.

3. Device according to claim 2, **characterized in that** the first pole (21) forms a first line surrounding the waveguide(s) (4), while the second pole (22) forms a second line, surrounding said first line .

4. Device according to claim 1, **characterized in that** the central conductor (1) of each waveguide is provided with fittings (7,8) capable of protecting the opening of said guide and of behaving as antennas.

5. Device according to claim 4, **characterized in that** the central conductor (1) has a concentric disk (5) of larger diameter than the opening of the waveguide (4) to protect the inside of said guide, which is positioned as closely as possible to the ECR area and is topped with a rod (6) arranged in coaxial alignment with the central conductor (1).

6. Device of claim 4, **characterized in that** the central conductor is ended by a plate (7) elongated along the longest axis of the magnetic circuit, one of the ends at least of said plate being provided with fittings (8) to be placed in contact with the surface of the source in order, to create a short-circuit, the width of the plate (7) being larger than the opening of the waveguide (4).

7. Device according to claim 6, **characterized in that** the width of the plate (7) is constant along its entire length.

8. Device according to claim 6, **characterized in that** the width of the plate (7) decreases away from the central conductor (1), and with respect to at least one side of said conductor (1).

9. Device of any of claims 1-8, **characterized in that** the treatment chamber comprises a body (10) with a cooling circuit (11), said body (10) comprising a housing for the assembly of the elongated magnetic circuit formed of the first line of magnets (21) according to the first polarization and the second line of magnets (22) according to an opposite polarization and surrounding the first line (21), which surrounds the waveguides (4) assembled in holes formed across the thickness of the body (10), the first and second lines of magnets are connected by a ferromagnetic plate (23), the body and the magnetic system being separated from the plasma by a shield (12).

10. Device of any of claims 1-9, **characterized in that** the central conductor (1) is a cylindrical rod centered with respect to the external conductor inserted in the body (10) with a good electric contact, a dielectric window (3) being placed inside of the guide (4) under the opening which is covered with the disk topped with the rod to be used as an antenna.

11. Device of any of claims 1-9, **characterized in that** the central conductor is a cylindrical rod centered with respect to the external conductor inserted into the body (10) by forming a good electric contact, a dielectric window (3) being placed inside of the guide (4) under the opening, which is covered with the elongated plate (7) along the axis of the injectors, said elongation being asymmetrical with respect to the central conductor for a waveguide located at a rounded end of the magnetic circuit, the elongation being only in the direction of the opposite end, symmetrical with respect to the central conductor for a waveguide located in the linear portion of the magnetic circuit, each elongated portion being provided with the fitting (8) used as a short-circuit.
